# FASCICULE DE BREVET EUROPEEN

(11) **EP 2 548 034 B1**
(45) Date de publication et mention de la délivrance du brevet: **20.04.2016**
(21) Numéro de dépôt: 11706486.5
(22) Date de dépôt: 24.02.2011
(51) Int. Cl.: G01R 11/24, H05K 5/02

(54) **BOÎTIER À DÉTECTION D'OUVERTURE**
GEHÄUSE MIT ÖFFNUNGSERKENNUNG
HOUSING WITH OPENING DETECTION

(30) Priorité: 15.03.2010 FR 1051841
(43) Date de publication de la demande: 23.01.2013
(73) Titulaire: Sagemcom Energy & Telecom SAS, 92500 Rueil-Malmaison (FR)
(72) Inventeur: ROLLAND, Patrick, F-92500 Rueil-Malmaison (FR)
(74) Mandataire: Lavialle, Bruno François Stéphane
(86) Numéro de dépôt international: PCT/EP2011/000907
(87) Numéro de publication internationale: WO 2011/113519

(56) Documents cités:
- EP-A1- 0 447 615
- EP-A1- 0 965 848
- EP-A1- 1 431 766
- EP-A1- 1 607 752
- DE-C- 492 979

## Description

La présente invention concerne un boîtier au moins partiellement obturé par un capot mobile. Un tel boîtier peut par exemple renfermer un équipement électrique ou électronique tel qu'un compteur électrique.

On connaît par exemple des compteurs électriques comportant un boîtier renfermant notamment l'unité de mesure de consommation et le bornier de raccordement du compteur d'une part au réseau public et d'autre part à l'installation électrique de l'utilisateur.

La partie du boîtier recevant le bornier est recouverte d'un capot amovible permettant aux techniciens d'accéder au bornier pour réaliser le branchement du compteur à l'installation. Le capot est maintenu en position sur le boîtier par l'intermédiaire d'une vis quart de tour prisonnière du capot et pivotant entre une position de verrouillage et une position de déverrouillage.

Lorsqu'un utilisateur du compteur souhaite frauder sur sa consommation électrique, il doit accéder au bornier. Pour révéler un tel accès, il est prévu des orifices en correspondance sur la tête de la vis et le capot pour permettre le passage d'un fil plombé dont la rupture permettrait à un technicien de détecter un démontage non autorisé du capot mobile. Le passage des techniciens est toutefois peu fréquent et se raréfie encore du fait du développement des relevés à distance des compteurs.

Il a été envisagé de disposer dans le boîtier un interrupteur qui est actionné par la vis amenée en position de déverrouillage et qui envoie une alerte sur le réseau de manière à révéler la fraude sans qu'une intervention ne soit nécessaire sur le compteur. Ceci suppose toutefois que la fraude soit réalisée lorsque le compteur est alimenté de sorte qu'un fraudeur qui profiterait d'une coupure d'alimentation sur le réseau, par exemple à l'occasion de travaux, pour découvrir le bornier pourrait échapper à la détection.

Pour remédier à cet inconvénient, il est connu des compteurs électriques pourvus d'un boîtier renfermant un circuit électronique de détection d'ouverture du capot hors alimentation du compteur. La vis qui est montée sur le capot pour pivoter entre une position de verrouillage et une position de déverrouillage comporte une extrémité pourvue d'au moins une dent pour engrener avec des dents d'une roue codeuse montée pour pivoter de façon unidirectionnelle en regard de plages du circuit de détection. La position de la roue codeuse par rapport aux plages du circuit de détection est mémorisée à chaque mise sous tension du compteur de telle manière qu'une simple comparaison permet de révéler un déplacement de la vis intervenu pendant une interruption d'alimentation du compteur. Il est cependant possible au fraudeur de recaler la position de la roue codeuse en lui faisant faire un tour complet avant le rétablissement de l'alimentation.

Il est connu le document EP 0 447 615 A exposant un boîtier à détection de position d'une roue codeuse.

Un but de l'invention est de fournir un moyen permettant de renforcer la fiabilité de la détection d'ouverture d'un capot de boîtier.

A cet effet, on prévoit, selon l'invention, un boîtier comportant au moins une partie fermée par un capot mobile et renfermant un circuit électronique de détection d'ouverture du capot, le capot étant pourvu de moyens de son verrouillage en position fermée comportant une vis qui est montée sur le capot pour pivoter entre une position de verrouillage et une position de déverrouillage et qui comporte une extrémité pourvue d'au moins une dent pour engrener avec des dents d'une roue codeuse montée pour pivoter en regard de plages du circuit de détection, caractérisé en ce que la vis est montée pour que ladite extrémité de la vis ait un positionnement présentant un jeu radial par rapport au boîtier de telle manière que le pivotement de la roue codeuse ait une amplitude dépendant du positionnement de ladite extrémité autorisé par le jeu radial.

Ainsi, le jeu radial introduit une composante aléatoire dans l'entraînement de la roue codeuse puisque l'utilisateur ne sait pas si la roue codeuse a tourné d'une ou plusieurs dents. Il ne peut donc ramener la roue codeuse dans sa position initiale après avoir ôté le capot car il ne peut déduire de la rotation de la vis la rotation de la roue codeuse.

Avantageusement, un cliquet est solidaire du boîtier pour engrener avec les dents de la roue codeuse et, de préférence, la vis et le boîtier sont équipés de moyens d'émission d'une pluralité de clics sonores actionnés par le pivotement de la vis entre ses deux positions et, de préférence encore, les moyens d'émission des clics sonores comportent une lamelle élastique solidaire de la vis ou du boîtier pour coopérer avec des reliefs du boîtier ou de la vis.

Le cliquet est généralement bruyant, sauf à utiliser des matériaux particuliers, de sorte qu'il pourrait donner une indication sonore sur la rotation de la roue codeuse. Les moyens d'émission de clics permettent de masquer les bruits éventuels du cliquet et de donner à la place une indication liée à la rotation de la vis mais pas à celle de la roue codeuse.

Selon un mode de réalisation, la vis possède un corps divisé en une première partie pourvue d'une tête de manoeuvre prisonnière du capot et une deuxième partie qui forme l'extrémité pourvue d'une dent et qui est prisonnière du boîtier, les deux parties de corps étant pourvues des moyens de leur liaison amovible en rotation et le boîtier présentant un axe sur lequel la deuxième partie de corps est engagée à pivotement avec le jeu radial.

Après retrait du capot, l'utilisateur n'a pas accès à la deuxième partie de corps ni à la roue codeuse sans recourir à un démontage supplémentaire du boîtier.

D'autres caractéristiques et avantages de l'invention ressortiront à la lecture de la description qui suit d'un mode de réalisation particulier non limitatif de l'invention.

Il sera fait référence aux dessins annexés, parmi lesquels :

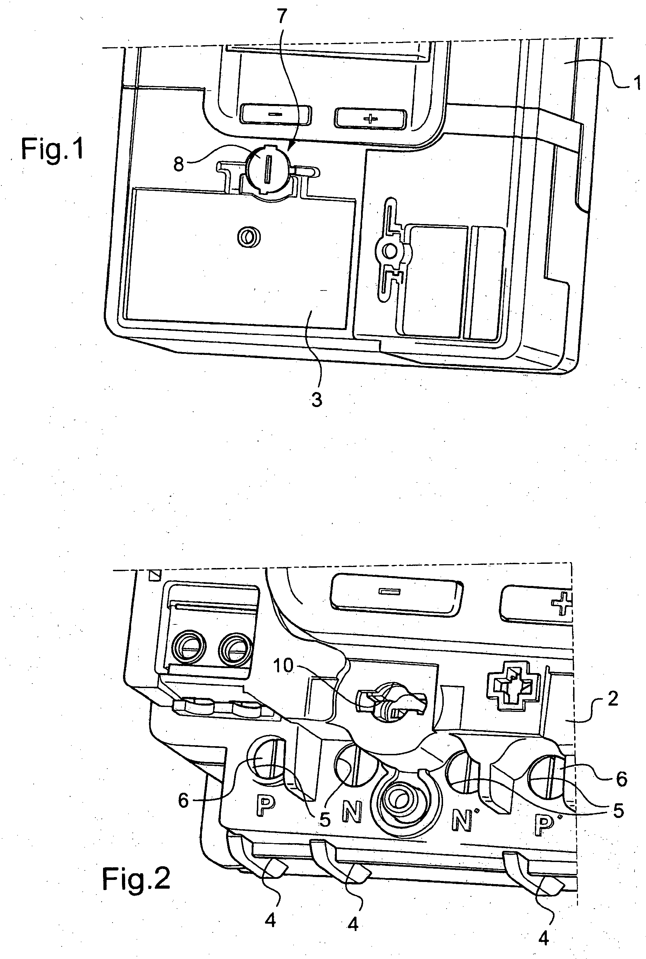

- la figure 1 est une vue partielle en perspective d'un compteur électrique comportant un boîtier conforme à l'invention ;
- la figure 2 est une vue analogue à la figure 1 du boîtier après retrait du capot supérieur ;
- la figure 3 est une vue analogue à la figure 1 du boîtier après retrait du capot inférieur ;
- la figure 4 est une vue agrandie en perspective de la zone IV de la figure 3 ;
- la figure 5 est une vue agrandie et partielle de la figure 4

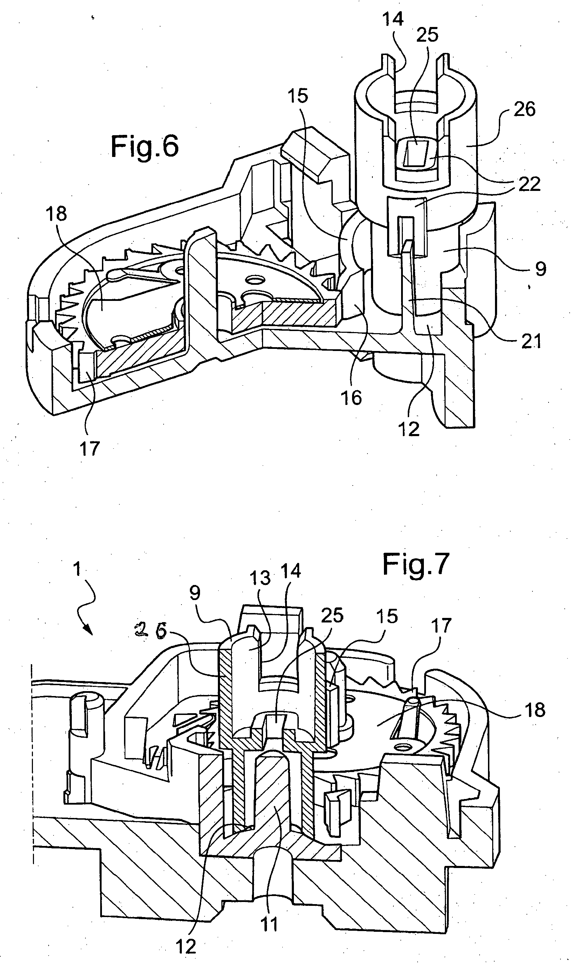

- la figure 6 est une vue en perspective, selon un autre angle et avec une coupe transversale, de la dite zone ;
- la figure 7 est une vue en perspective de la dite zone, toujours selon un autre angle et avec une coupe selon le plan VI de la figure 6.

L'invention est ici décrite en application à un compteur qui comprend une unité électrique et un bornier 100 permettant le raccordement d'une installation au réseau public de distribution d'électricité via l'unité électrique. L'unité électrique, connue en elle-même, comporte notamment un module de mesure de consommation de l'installation et un circuit de détection de fraude connus en eux-mêmes.

L'unité électrique et le bornier 100 sont enfermés dans un boîtier généralement désigné en 1 comportant une partie recouverte par un capot inférieur 2 lui-même recouvert par un capot supérieur 3. Ladite partie loge le bornier 100 et le capot inférieur 2 comporte des orifices 4 de passage des câbles et des orifices 5 découvrant les têtes 6 des vis de serrage des câbles dans le bornier 100. Le capot inférieur 2 est recouvert par le capot supérieur 3 qui vient notamment masquer les orifices 5 pour empêcher un démontage des câbles. Le capot supérieur 3 est associé à des moyens de détection d'ouverture. Ces moyens de détection d'ouverture sont raccordés au circuit de détection appartenant à l'unité électrique.

Le capot supérieur 3 est fixé au moyen d'une vis quart de tour, généralement désignée en 7, comportant de façon connue en elle-même une tête 8 de manoeuvre et un corps divisé en une première partie et une deuxième partie 9 (seule partie visible sur les figures). Cet agencement en deux parties est classique.

La tête 8 et la première partie de corps sont solidaires l'une de l'autre et montées pivotantes sur le capot supérieur 3 en étant retenues prisonnières de celui-ci. La première partie de corps a une extrémité libre pourvue de deux ergots s'étendant symétriquement en saillie latérale. L'extrémité libre de la première partie de corps est destinée à être introduite dans un orifice 10 du capot inférieur 2. L'orifice 10 a un contour circulaire dans lequel sont ménagées deux encoches symétriques de telle manière, que l'extrémité libre de la première partie de corps peut passer dans l'orifice 10 lorsque les ergots sont en regard des encoches, la vis 7 étant alors en position de déverrouillage. On comprend que, lorsque la vis 7 est pivotée à 90° par rapport à la position de déverrouillage, les ergots ne peuvent passer par les encoches, la vis 7 étant alors dans une position dite de verrouillage.

La deuxième partie de corps 9 est engagée à pivotement sur un axe 11 s'étendant en saillie d'une portion interne 12 du boîtier 1 derrière le capot inférieur 2. La deuxième partie de corps 9 comporte une première extrémité en appui contre la portion interne 12 et une deuxième extrémité qui s'étend au voisinage de l'orifice 10 et qui est pourvue d'un logement 13 pour recevoir l'extrémité libre de la première partie de corps. Le logement 13 est délimité latéralement par une paroi cylindrique dans laquelle sont ménagées deux encoches 14 pour recevoir les ergots de l'extrémité libre de la première partie de corps et ainsi lier en rotation les deux parties de corps l'une à l'autre. La portion interne 12 a une forme bombée sur laquelle repose la première extrémité de la deuxième partie de corps 9.

La première extrémité de la deuxième partie de corps 9 est en outre pourvue d'un bras élastique 15 s'enroulant partiellement autour de ladite deuxième extrémité pour avoir une extrémité libre pourvue d'une dent 16 pour engrener avec des dents 17 d'une roue codeuse 18. La roue codeuse 18 est montée sur une partie du boîtier 1 pour pivoter en regard de plages 20 du circuit de détection et est pourvue de pattes de contact avec lesdites plages. Un cliquet 19 est solidaire du boîtier 1 pour engrener avec les dents 17 de la roue codeuse 18. Le fonctionnement du circuit de détection est connu en lui-même et ne sera pas décrit plus en détail ici.

Selon une caractéristique particulière de l'invention, la deuxième partie de corps 9 est montée sur l'axe 11 pour avoir un positionnement présentant, par rapport au boîtier 1, un jeu radial de telle manière que, lors du pivotement de la vis 7 entre ses deux positions, la dent 16 engrène avec une ou plusieurs (ici deux ou trois) dents 17 de la roue codeuse 18 selon le positionnement de ladite extrémité autorisé par le jeu radial. On voit ici que l'axe 11 a un diamètre très inférieur au diamètre intérieur de la première extrémité de la deuxième partie de corps 9.

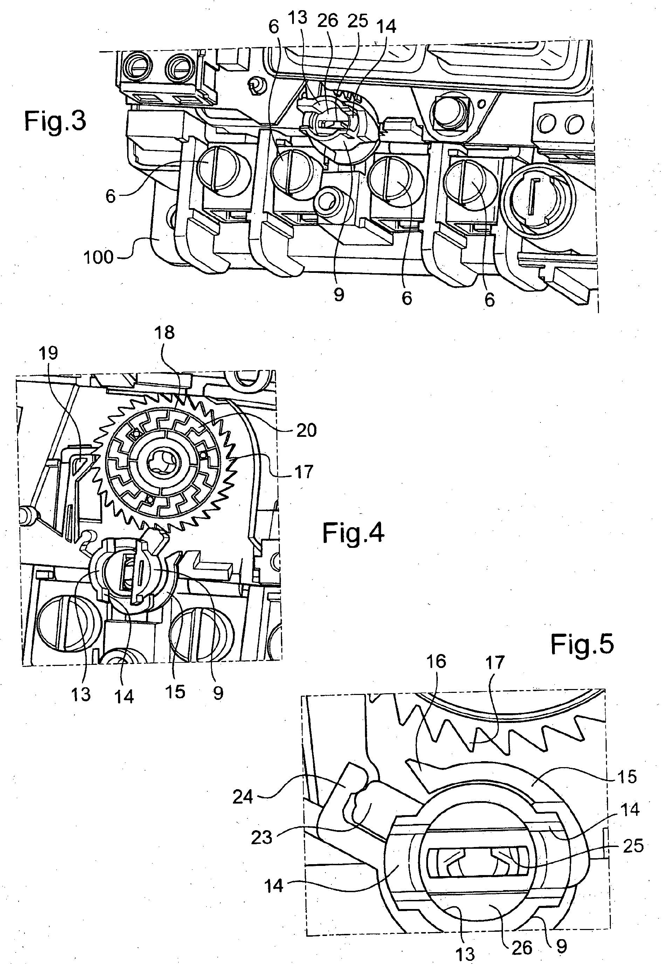

Ainsi, des rotations de la vis 7 entre ses positions de verrouillage et de déverrouillage, de mêmes amplitudes, peuvent entraîner des pivotements de la roue codeuse 18 d'amplitudes différentes selon la proximité de la première extrémité de la deuxième partie de corps 9 avec la roue codeuse 18. Si la première extrémité de la deuxième partie de corps 9 est proche de la roue codeuse 18, la dent 16 va provoquer un déplacement angulaire équivalent au secteur angulaire correspondant à trois dents de la roue codeuse (voir la figure 5) tandis que si la première extrémité de la deuxième partie de corps 9 est éloignée de la roue codeuse 18, la dent 16 va provoquer un déplacement angulaire de la roue codeuse 18 équivalent au secteur angulaire correspondant à une dent de la roue codeuse 18.

Pour éviter que les chocs du cliquet 19 contre les dents 17 ne révèlent à l'utilisateur l'amplitude du pivotement de la roue codeuse 18, il est possible d'utiliser pour le cliquet 19 et les dents 17 des matériaux plastiques relativement souples permettant d'assourdir et d'amoindrir les chocs. Les matières plastiques utilisables sont par exemple le polyamide ou le polyoxyméthylène.

La raideur du bras 15 peut aussi être adaptée pour réduire le bruit de cliquetis.

Dans le mode de réalisation préféré de l'invention, la vis et le boîtier 1 sont équipés de moyens d'émission d'une pluralité de clics sonores actionnés par le pivotement de la vis entre ses deux positions. Les moyens d'émission des clics sonores comportent ici une lamelle élastique 21 ayant une extrémité solidaire pour s'étendre perpendiculairement en saillie de la portion interne 12 du boîtier 1 et avoir une extrémité libre pour coopérer avec deux reliefs 22 solidaires de la deuxième partie de corps 9 de la vis 7 pour s'étendre parallèlement à celui-ci sur la trajectoire de l'extrémité libre de la lamelle 21 lorsque la vis 7 est déplacée entre ses deux positions. On comprend que le pivotement de la vis 7 entre ses deux positions va provoquer l'émission de deux clics sonores quelle que soit l'amplitude du pivotement de la roue codeuse 18.

Pour faciliter le montage de la vis 7 et plus particulièrement l'insertion de l'extrémité libre de la première partie de corps dans le logement 13 de la deuxième extrémité de la deuxième partie de corps 9, la première extrémité de la deuxième partie de corps 9 de la vis 7 est pourvue d'un index 23 en saillie radiale pour dans une potence élastique 24 (figure 5) et maintenir la deuxième partie de corps 9 dans une position de montage (à 180° de la position de déverrouillage) permettant la réception des ergots de la première partie de corps dans les encoches 14. Il est également prévu une empreinte 25 dans le fond 26 du logement 13. L'empreinte 25 est agencée pour coopérer avec un outil, ici un tournevis plat, de manière à déplacer en rotation la deuxième partie de corps 9 au travers du capot inférieur 2.

Bien entendu, l'invention n'est pas limitée aux modes de réalisations décrits mais englobe toute variante entrant dans le champ de l'invention telle que définie par les revendications.

En particulier, bien que l'invention ait été décrite en application à un compteur électrique, le boîtier de l'invention est utilisable avec d'autre type d'équipements électriques, électroniques ou autres.

En variante, la portion interne 12, sur laquelle repose la première extrémité de la deuxième partie de corps 9, a une forme plane.

La roue codeuse peut être une roue à rochet ou non.

Les moyens de liaison en rotation des parties de corps de la vis peuvent être différents de ceux décrits et comprendre par exemple des crabots. La vis peut alternativement être en une seule partie.

## Revendications

1. Boîtier (1) comportant au moins une partie fermée par un capot mobile (3) et renfermant un circuit électronique de détection d'ouverture du capot, le capot étant pourvu de moyens de son verrouillage en position fermée comportant une vis (7) qui est montée sur le capot pour pivoter entre une position de verrouillage et une position de déverrouillage et qui comporte une extrémité pourvue d'au moins une dent (16) pour engrener avec des dents (17) d'une roue codeuse (18) montée pour pivoter en regard de plages du circuit de détection, **caractérisé en ce que** la vis est montée pour que ladite extrémité de la vis ait un positionnement présentant un jeu radial par rapport au boîtier de telle manière que le pivotement de la roue codeuse ait une amplitude dépendant du positionnement de ladite extrémité autorisé par le jeu radial.

2. Boîtier selon la revendication 1, dans lequel un cliquet (19) est solidaire du boîtier (1) pour engrener avec les dents (17) de la roue codeuse (18).

3. Boîtier selon la revendication 2, dans lequel la vis (7) et le boîtier (1) sont équipés de moyens (21, 22) d'émission d'une pluralité de clics sonores actionnés par le pivotement de la vis entre ses deux positions.

4. Boîtier selon la revendication 3, dans lequel les moyens d'émission des clics sonores comportent une lamelle élastique (21) solidaire de la vis (7) ou du boîtier (1) pour coopérer avec des reliefs (22) du boîtier ou de la vis.

5. Boîtier selon la revendication 1, dans lequel la dent (16) est solidaire d'un bras élastique (15) pour s'étendre radialement en saillie de ladite extrémité de la vis (7).

6. Boîtier selon la revendication 1, dans lequel la vis (7) possède un corps divisé en une première partie pourvue d'une tête de manoeuvre prisonnière du capot et une deuxième partie (9) qui forme l'extrémité pourvue d'une dent et qui est prisonnière du boîtier, les deux parties de corps étant pourvues des moyens (13, 14) de leur liaison amovible en rotation et le boîtier (1) présentant un axe (11) sur lequel la deuxième partie de corps est engagée à pivotement avec le jeu radial.

7. Boîtier selon la revendication 6, dans lequel la deuxième partie (9) est pourvue d'une empreinte (25) agencée pour coopérer avec un outil de manière à déplacer en rotation la deuxième partie de corps au travers du boîtier (1) après retrait du capot (3).

8. Boîtier selon la revendication 6, dans lequel ladite extrémité de la deuxième partie de corps (9) de la vis (7) est pourvue d'un index (23) en saillie radiale pour maintenir la vis (7) dans une position de montage.

## Patentansprüche

1. Gehäuse (1), das mindestens einen durch eine bewegliche Abdeckung (3) verschlossenen Teil umfasst und eine elektronische Schaltung zum Erfassen des Öffnens der Abdeckung enthält, wobei die Abdeckung mit Mitteln für ihre Verriegelung in geschlossener Position versehen ist, die eine Schraube (7) umfassen, die an der Abdeckung drehbar zwischen einer Verriegelungsposition und einer Entriegelungsposition gelagert ist und ein Ende umfasst, das mit mindestens einem Zahn (16) versehen ist, um mit Zähnen (17) einer Kodierscheibe (18) in Eingriff zu kommen, die gegenüber von Bereichen der Erfassungsschaltung drehbar gelagert ist, **dadurch gekennzeichnet, dass** die Schraube so gelagert ist, dass das genannte Ende der Schraube eine Positionierung hat, die ein radiales Spiel gegenüber dem Gehäuse aufweist, derart, dass das Drehen der Kodierscheibe eine Amplitude hat, die von der Positionierung des genannten Endes abhängt, die von dem radialen Spiel zugelassen wird.

2. Gehäuse nach Anspruch 1, wobei eine Sperrklinke (19) fest mit dem Gehäuse (1) verbunden ist, um mit den Zähnen (17) der Kodierscheibe (18) in Eingriff zu kommen.

3. Gehäuse nach Anspruch 2, wobei die Schraube (7) und das Gehäuse (1) mit Mitteln (21, 22) zum Aussenden einer Vielzahl von Klickgeräuschen ausgestattet sind, die durch das Drehen der Schraube zwischen ihren beiden Positionen hervorgerufen werden.

4. Gehäuse nach Anspruch 3, wobei die Mittel zum Aussenden der Klickgeräusche ein elastisches Plättchen (12) umfassen, das fest mit der Schraube (7) oder dem Gehäuse (1) verbunden ist, um mit Erhebungen (22) des Gehäuses oder der Schraube zusammenzuwirken.

5. Gehäuse nach Anspruch 1, wobei der Zahn (16) fest mit einem elastischen Arm (15) verbunden ist, um sich radial vorstehend von dem genannten Ende der Schraube (7) zu erstrecken.

6. Gehäuse nach Anspruch 1, wobei die Schraube (7) einen Körper hat, der in einen ersten Teil, der mit einem Betätigungskopf versehen ist, der in der Abdeckung gefangen ist, sowie in einen zweiten Teil (9) unterteilt ist, der das mit einem Zahn versehene Ende bildet und in dem Gehäuse gefangen ist, wobei die beiden Körperteile mit Mitteln (13, 14) für ihre lösbare Drehverbindung versehen sind, und wobei das Gehäuse (1) eine Achse (11) aufweist, auf der der zweite Körperteil mit dem radialen Spiel drehbar aufgesteckt ist.

7. Gehäuse nach Anspruch 6, wobei der zweite Teil (9) mit einem Eindruck (25) versehen ist, der so ausgebildet ist, dass er mit einem Werkzeug zusammenwirkt, derart, dass der zweite Körperteil nach Abnehmen der Abdeckung (3) durch das Gehäuse (1) hindurch gedreht wird.

8. Gehäuse nach Anspruch 6, wobei das genannte Ende des zweiten Körperteils (9) der Schraube (7) mit einem radial vorstehenden Index (23) versehen ist, um die Schraube (7) in einer Montageposition zu halten.

## Claims

1. A box (1) comprising at least one portion that is closed by a movable cover (3) and that contains an electronic detection circuit for detecting opening of the cover, the cover being provided with means for locking it in the closed position, said means comprising a screw (7) that is mounted on the cover to pivot between a locking position and an unlocking position, and having an end provided with at least one tooth (16) for meshing with teeth (17) of a code wheel (18) mounted to pivot in register with pads of the detection circuit, the box being **characterized in that** the screw is mounted so that said end of the screw presents positioning with radial clearance relative to the box in such a manner that the pivoting of the code wheel has an amplitude that depends on the positioning of said end as authorized by the radial clearance.

2. A box according to claim 1, wherein a pawl (19) is secured to the box (1) in order to mesh with the teeth (17) of the code wheel (18).

3. A box according to claim 2, wherein the screw (7) and the box (1) are fitted with means (21, 22) for emitting a plurality of audible clicks, which means are actuated by pivoting the screw between its two positions.

4. A box according to claim 3, wherein the means for emitting audible clicks comprise a spring blade (21) secured to the screw (7) or to the box (1) to co-operate with portions in relief (22) of the box or of the screw.

5. A box according to claim 1, wherein the tooth (16) is secured to a resilient arm (15) to extend radially projecting from said end of the screw (7).

6. A box according to claim 1, wherein the screw (7) possesses a shank that is subdivided into a first portion having a drive head held captive in the cover and a second portion (9) that forms the end provided with a tooth and that is held captive in the box, the two shank portions being provided with means (13, 14) enabling them to be releasably connected together in rotation, and the box (1) presenting a pin (11) on which the second shank portion is pivotally engaged with the radial clearance.

7. A box according to claim 6, wherein the second portion (9) is provided with a socket (25) arranged to co-operate with a tool so as to pass through the box (1) after the cover (3) has been removed and turn the second shank portion.

8. A box according to claim 6, wherein said end of the second shank portion (9) of the screw (7) is provided with a radially-projecting index (23) for holding the screw (7) in an assembly position.
